# EUROPEAN PATENT APPLICATION

(11) **EP 2 544 221 A1**
(43) Date of publication of application: **09.01.2013**
(21) Application number: 11750819.2
(22) Date of filing: 04.03.2011
(51) Int. Cl.: H01L 21/20, H01L 21/205, H01L 21/268

(54) **CRYSTALLINE FILM, DEVICE, AND PRODUCTION METHODS FOR CRYSTALLINE FILM AND DEVICE**

(30) Priority: 05.03.2010 JP 2010049860
(71) Applicant: Namiki Seimitsu Houseki kabushikikaisha, Adachi-ku Tokyo 123-8511 (JP); Disco Corporation, Tokyo 143-8580 (JP)
(72) Inventor: AIDA, Hideo, Tokyo 123-8511 (JP); AOTA, Natsuko, Tokyo 123-8511 (JP); HOSHINO, Hitoshi, Tokyo 143-8580 (JP); FURUTA, Kenji, Tokyo 143-8580 (JP); HAMAMOTO, Tomosaburo, Tokyo 143-8580 (JP); HONJO, Keiji, Tokyo 143-8580 (JP)
(74) Representative: Skone James, Robert Edmund
(86) International application number: PCT/JP2011/055085
(87) International publication number: WO 2011/108710

(57) **Abstract**

Provided are a crystalline film in which variations in the crystal axis angle after separation from a substrate for epitaxial growth have been eliminated, and various devices in which the properties thereof have been improved by including the crystalline film. Also provided are manufacturing methods for the crystalline film and the devices. A crystalline film having a thickness in the range of 300 µm or more and 10 mm or less is formed by epitaxial growth on a surface of a single crystal substrate, which is the substrate for epitaxial growth. The crystalline film is subsequently separated from the single crystal substrate. A reformed region pattern is formed by, when a relative position of the reformed region pattern in a thickness direction of the crystalline film in which warpage has occurred after separation is assumed to be 0% at a surface thereof on a concavely warped side and 100% at a surface thereof on a convexly warped side, concentrating a pulsed laser onto an internal portion of the crystalline film in a range of 3% or more and less than 50% in the thickness direction to scan the internal portion, and using multiphoton absorption by the pulsed laser, thereby reducing or eliminating the amount of warpage of the crystalline film and reducing or eliminating variations in the crystal axis angle.

## Description

### Technical Field

The present invention relates to a crystalline film produced by using a substrate for epitaxial growth, a device, and manufacturing methods for the crystalline film and the device.

### Background Art

A nitride semiconductor represented by gallium nitride (GaN) has a wide band gap and is capable of blue light emission, and hence the nitride semiconductor is widely used in a light emitting diode (LED), a semiconductor laser (LD), and the like. For example, a white LED in which a blue LED containing GaN and a yellow light emitting element are combined is prevalent as a backlight for a liquid crystal display (LCD) of a cellular phone or the like. In addition, the white LED has advantages such as low power consumption and long life, and hence the white LED is expected as a light source excellent in environmental friendliness that replaces a fluorescent lamp or an incandescent lamp, and is actively studied and developed.

A crystalline film of the nitride semiconductor is formed by epitaxial growth on the surface of a substrate for epitaxial growth (hereinafter, referred to as a "substrate for growth") represented by a sapphire single crystal substrate. However, the substrate for growth and the crystalline film have different lattice constants and different thermal expansion coefficients, and hence it has been extremely difficult to grow the crystalline film to such a thickness that the crystalline film is capable of free-standing (for example, 300 µm or more).

To cope with this, there has been devised a method in which the crystalline film is grown on the surface of the substrate for growth by a hydride vapor phase epitaxy method (HVPE method). The HVPE method has a growth rate higher than those of other crystal growth methods such as a metal organic vapor phase epitaxy method (MOVPE method) and a molecular beam epitaxy method (MBE method), and hence a thick crystalline film can be formed.

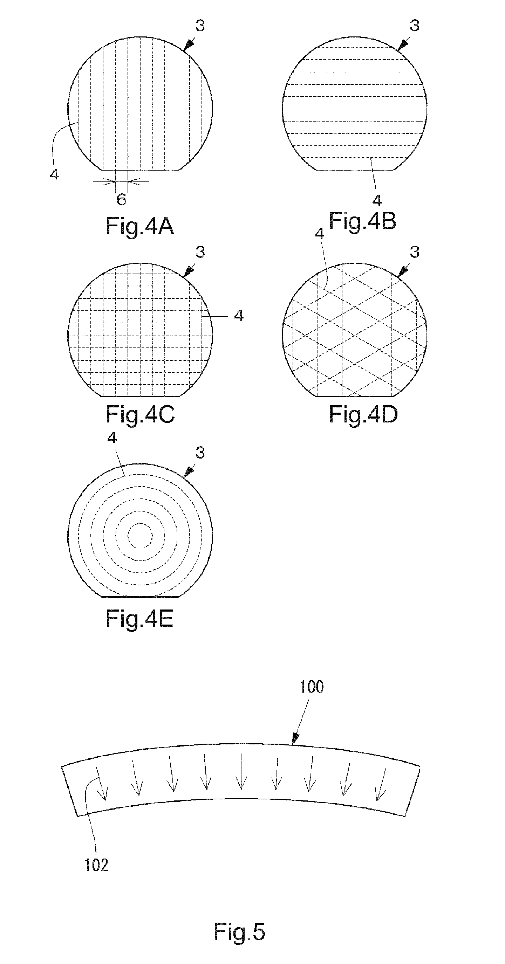

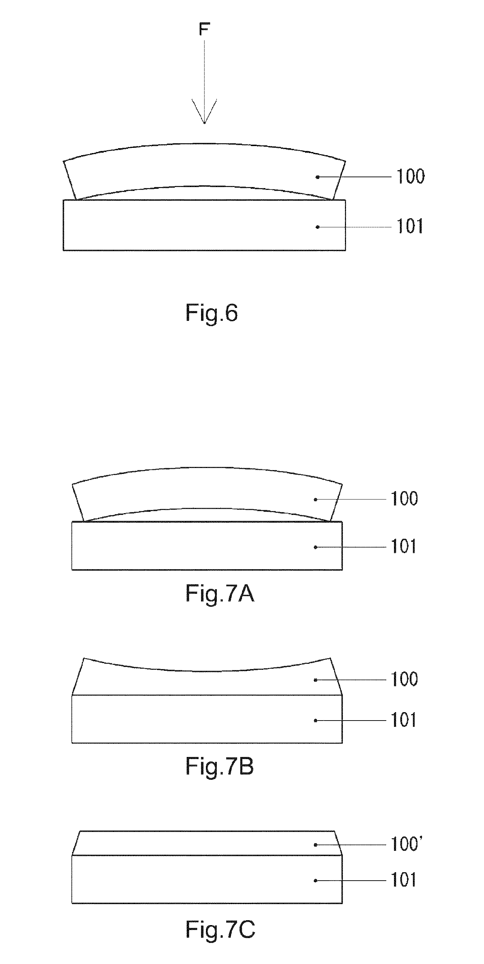

However, even when the crystalline film could be grown to such a thickness that the crystalline film is capable of free-standing, there has been a problem in that, in the process of separating the substrate for growth from the crystalline film, an internal strain resulting from differences in thermal expansion coefficient and lattice constant between the substrate for growth and the crystalline film of the nitride semiconductor is released, and warpage occurs in a crystalline film 100, as illustrated in FIG. 5. As illustrated in FIG. 6, even if the warped crystalline film 100 is to be attached by press-bonding to a polishing board 101 to be polished, when the warpage amount is extremely large, a pressing force F during the press bonding needs to be increased, and hence there has been a fear that the crystalline film may be damaged by the press of the large pressing force F.

To cope with this, as illustrated in FIG. 7A, the warped crystalline film 100 is attached to the polishing board 101 as it is, the surface of the crystalline film 100 is polished in that state and, as illustrated in FIG. 7B, a concave surface as the other surface of the crystalline film 100 is further polished. FIG. 7C illustrates a crystalline film 100' having both polished surfaces.

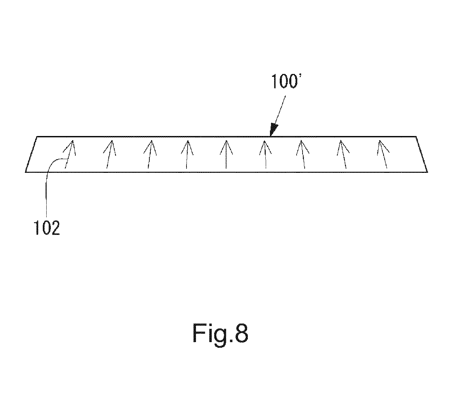

The crystalline film 100' illustrated in FIG. 7C is formed into a parallel plate shape with both surfaces polished so as to be in parallel to each other in appearance, but the shape of the crystalline film 100' is obtained by polishing the originally-warped crystalline film 100. As illustrated in FIG. 5, with regard to crystal axes 102 inside the warped crystalline film 100, a difference in the angle of the crystal axis 102 is increased as the crystal axis goes from the central portion of the crystalline film 100 to the end portion thereof. Consequently, both surfaces of the crystalline film 100 are polished while the difference in the angle of the crystal axis 102 is maintained, and hence, as illustrated in FIG. 8, the polished crystalline film 100' also has variations in the angle of the crystal axis 102.

When the crystalline film 100' is made of the nitride semiconductor, in a case where there are variations in the crystal axis 102, the composition of a growth layer epitaxially grown on the surface of the nitride semiconductor varies. Specifically, for example, when a light emitting device is produced by using the crystalline film 100' described above, an emission wavelength in the plane of the crystalline film 100' varies due to variations in the composition of the epitaxial layer. As a result, there is a fear that the produced light emitting device does not have the identical emission wavelength, but have variations in emission wavelength.

To cope with this, Patent Literature 1 discloses a method in which, in a concavely warped crystalline film, the warpage of the crystalline film is reduced by polishing the surface on the concavely warped side to form a damaged layer.

### Citation List

### Patent Literature

[PTL 1] JP 2005-136167 A

### Summary of Invention

### Technical Problem

However, in the manufacturing method for the crystalline film described in Patent Literature 1, there has been a problem in that the warpage of the crystalline film is reduced in a state in which the damaged layer is formed, but, when the damaged layer is removed from the crystalline film during the production of a device, the crystalline film is warped again and variations occur in the crystal axis.

In addition, due to variations in the crystalline film, even if a subsequent step such as photolithography or division into individual chips is to be executed after the formation of the crystalline film, the execution thereof becomes difficult.

Further, from the viewpoint of economy in the device production, a large-size nitride single crystal substrate having a size of two inches (diameter of 50 mm) or more is in demand. However, there has been a problem in that, when the size of the substrate is increased, the in-plane unevenness of substrate properties becomes conspicuous due to the warpage, and the increase in area becomes pointless. Further, the variations in crystal axis render the composition of InGaN of an active layer of a light emitting device non-uniform, and hence variations in emission wavelength occur when the light emitting device is formed.

Moreover, in the manufacturing method for the crystalline film described in Patent Literature 1, the formation of the damaged layer is performed by mechanical polishing, and hence, in order to eliminate the warpage of the crystalline film, the degree of reduction in warpage amount needs to be checked every time the mechanical polishing is performed and the polishing step needs to be suspended every time the checking is made. As a result, the manufacturing method requires time and labor.

The present invention has been achieved in view of the above-mentioned problems, and an object thereof is to provide a crystalline film in which variations in crystal axis are eliminated after separation from a substrate for growth, a device in which properties are improved by including the crystalline film, and manufacturing methods for the crystalline film and the device.

The above-mentioned object is attained by the present invention as follows.
That is, according to the present invention, there is provided a crystalline film, including a reformed region pattern formed in an internal portion of the crystalline film, in which the crystalline film has a thickness of 300 µm or more and 10 mm or less.

Further, in a crystalline film according to an embodiment of the present invention, the reformed region pattern is preferably formed by a pulsed laser.

Further, in a crystalline film according to another embodiment of the present invention, when a relative position of the reformed region pattern in a thickness direction of the crystalline film is assumed to be 0% at one surface of the crystalline film and 100% at another surface of the crystalline film, the reformed region pattern is preferably provided in a range of 3% or more and 95% or less in the thickness direction of the crystalline film.

Further, in a crystalline film according to another embodiment of the present invention, the reformed region pattern is preferably provided in a range of 3% or more and less than 50% in the thickness direction of the crystalline film.

Further, in a crystalline film according to another embodiment of the present invention, the reformed region pattern is preferably provided in parallel to the one surface of the surfaces of the crystalline film.

Further, in a crystalline film according to another embodiment of the present invention, the reformed region pattern preferably has, in a planar direction of the crystalline film, any one of a stripe shape, a lattice shape, a shape in which a plurality of polygons are disposed, a shape in which a plurality of circles or ellipses identical in shape and size are regularly disposed, a concentric shape, a spiral shape, and a shape substantially symmetric with respect to a straight line passing through a center point of the crystalline film or with respect to the center point of the crystalline film.

Further, in a crystalline film according to another embodiment of the present invention, the reformed region pattern preferably has, in a planar direction of the crystalline film, any one of a stripe shape, a lattice shape, a shape in which a plurality of polygons are disposed, and a concentric shape, and the reformed region pattern preferably has, in the planar direction of the crystalline film, a pitch between lines constituting the reformed region pattern, the pitch being in a range of 50 µm or more and 2,000 µm or less.

Further, in a crystalline film according to another embodiment of the present invention, the pitch is preferably in a range of 100 µm or more and 1,000 µm or less.

Further, in a crystalline film according to another embodiment of the present invention, the crystalline filmpreferably has a diameter of 50 mm or more and 300 mm or less.

Further, in a crystalline film according to another embodiment of the present invention, the crystalline film is preferably a nitride semiconductor crystal.

Further, according to the present invention, there is provided a device, including the crystalline film of the present invention.

Further, according to the present invention, there is provided a manufacturing method for a crystalline film, including: forming the crystalline film having a thickness of 300 µm or more and 10 mm or less on a surface of a single crystal substrate by epitaxial growth; subsequently separating the crystalline film from the single crystal substrate; and subsequently forming a reformed region pattern by, when a relative position of the reformed region pattern in a thickness direction of the crystalline film in which warpage has occurred after the separating from the single crystal substrate is assumed to be 0% at a surface of the crystalline film on a concavely warped side and 100% at a surface of the crystalline film on a convexly warped, concentrating a pulsed laser onto an internal portion of the crystalline film in a range of 3% or more and less than 50% in the thickness direction to scan the internal portion, and using multiphoton absorption by the pulsed laser.

Further, in a manufacturing method for a crystalline film according to an embodiment of the present invention, the forming of the reformed region pattern preferably includes providing the reformed region pattern in parallel to one surface of the crystalline film.

Further, in a manufacturing method for a crystalline film according to another embodiment of the present invention, the forming of the reformed region pattern preferably includes forming the reformed region pattern into, in a planar direction of the crystalline film, any one of a stripe shape, a lattice shape, a shape in which a plurality of polygons are disposed, a shape in which a plurality of circles or ellipses identical in shape and size are regularly disposed, a concentric shape, a spiral shape, and a shape substantially symmetric with respect to a straight line passing through a center point of the crystalline film or with respect to the center point of the crystalline film.

Further, in a manufacturing method for a crystalline film according to another embodiment of the present invention, the forming of the reformed region pattern preferably includes: forming the reformed region pattern into, in a planar direction of the crystalline film, any one of a stripe shape, a lattice shape, a shape in which a plurality of polygons are disposed, and a concentric shape; and setting, in the planar direction of the crystalline film, a pitch between lines constituting the reformed region pattern to be in a range of 50 µm or more and 2,000 µm or less.

Further, in a manufacturing method for a crystalline film according to another embodiment of the present invention, the setting of the pitch preferably includes setting the pitch to be in a range of 100 µm or more and 1,000 µm or less.

Further, in a manufacturing method for a crystalline film according to another embodiment of the present invention, the crystalline film preferably has a diameter of 50 mm or more and 300 mm or less.

Further, in a manufacturing method for a crystalline film according to another embodiment of the present invention, the crystalline film is preferably a nitride semiconductor crystal.

Further, according to the present invention, there is provided a manufacturing method for a device, including: forming a crystalline film having a thickness of 300 µm or more and 10 mm or less on a surface of a single crystal substrate by epitaxial growth; subsequently separating the crystalline film from the single crystal substrate; subsequently forming a reformed region pattern by, when a relative position of the reformed region pattern in a thickness direction of the crystalline film in which warpage has occurred after the separating from the single crystal substrate is assumed to be 0% at a surface of the crystalline film on a concavely warped side and 100% at a surface of the crystalline film on a convexly warped, concentrating a pulsed laser onto an internal portion of the crystalline film in a range of 3% or more and less than 50% in the thickness direction to scan the internal portion, and using multiphoton absorption by the pulsed laser, thereby manufacturing the crystalline film; then performing at least an element portion formation step of performing at least a patterning process on the crystalline film to produce an element portion functioning as an element selected from the group consisting of a light emitting element, a photovoltaic element, and a semiconductor element; and manufacturing the device including the element portion and the crystalline film having a size substantially corresponding to the element portion.

### Advantageous Effects of Invention

According to the present invention described above, it becomes possible to control the warpage shape of the crystalline film subjected to double-sided polishing, which has such a thickness that the crystalline film is capable of free-standing, and to obtain the crystalline film in which the warpage amount is reduced or eliminated with high precision. Consequently, through flattening of the crystalline film, it becomes possible to facilitate a subsequent step, and reduce or eliminate variations in crystal axis angle inside the crystalline film.

In addition, through the use of the pulsed laser, it is possible to concentrate energy in a short time width to obtain a high peak output, and hence the use of the pulsed laser is preferable for the formation of the reformed region pattern and, by the irradiation condition and irradiation position of the pulsed laser, it is possible to uniquely control the warpage amount, and hence it becomes possible to shorten the step of reducing or eliminating the warpage amount as compared with a conventional step.

Further, when the relative position of the reformed region pattern in the thickness direction of the crystalline film is assumed to be 0% at one surface of the crystalline film as a reference value and 100% at the other surface thereof, the reformed region pattern is formed in the range of 3% or more and 95% or less, and further in the range of 3% or more and less than 50% in the thickness direction of the crystalline film. In this manner, it is possible to form the reformed region pattern without affecting the surface of the crystalline film, and also reduce or eliminate the warpage amount occurring in the crystalline film subjected to double-sided polishing. Further, in a case where the reformed region pattern is formed at a position of at least 3% or more and less than 50% in the thickness direction of the crystalline film, it becomes possible to cause the reformed region pattern to remain in the internal portion of the crystalline film even when the both surfaces of the crystalline film are subjected to the polishing in the subsequent step. Consequently, the recurrence of the warpage in the crystalline film subjected to double-sided polishing is prevented and the occurrence of or increase in variations in crystal axis angle can be prevented.

Moreover, by providing the reformed region pattern in parallel to the one surface of the crystalline film, it is possible to facilitate the reduction or elimination of the warpage amount and prevent the occurrence of the strain in the shape of the crystalline film.

In addition, the reformed region pattern has the lattice shape, the shape in which polygons are disposed, the concentric shape, the spiral shape, the shape in which a plurality of circles or ellipses identical in shape and size are regularly disposed, or the shape substantially symmetric with respect to the straight line passing through the center point of the crystalline film or with respect to the center point of the crystalline film. In this manner, it is possible to evenly reduce or eliminate the warpage amount of the crystalline film subjected to double-sided polishing.

When the reformed region pattern has the stripe shape, it becomes possible to unevenly reduce or eliminate the warpage amount of the crystalline film subjected to double-sided polishing, and the pulsed laser irradiation step can be further facilitated.

Further, by setting the pitch spacing of the reformed region pattern to the range of 50 µm or more and 2,000 µm or less, and further to the range of 100 µm or more and 1,000 µm or less, it becomes possible to secure a change in the warpage amount of the crystalline film subjected to double-sided polishing and mass productivity thereof.

Further, even when a large-diameter substrate having a diameter of 50 mm or more and 300 mm or less is used as a substrate for growth and a large-diameter crystalline film having the same size is produced, variations in the crystal axis angle of the crystalline film subjected to double-sided polishing are reduced or eliminated by reducing or eliminating the warpage amount, and hence it becomes possible to prevent in-plane unevenness.

Moreover, by constituting various devices by using the crystalline film according to the present invention, the crystalline film in which variations in crystal axis angle are reduced or eliminated is used, and hence it is possible to provide various devices in which quality and device properties are improved. In addition, through the use of a nitride semiconductor crystal in the crystalline film, it becomes possible to improve the quality and properties of various devices including the nitride semiconductor crystal.

### Brief Description of Drawings

[FIG.1A, FIG.1B and FIG.1C] Schematic diagrams illustrating an epitaxial growth step for a crystalline film according to an embodiment of the present invention.
[FIG.2] A schematic diagram illustrating the crystalline film separated from a substrate for growth after the epitaxial growth.
[FIG.3] A schematic diagram illustrating a reformed region pattern formation step in an internal portion of the crystalline film according to the embodiment of the present invention.
[FIG.4A, FIG.4B, FIG.4C, FIG.4D and FIG.4E] Schematic diagrams illustrating pattern shapes and pitches of a reformed region pattern according to the embodiment of the present invention.
[FIG. 5] A schematic diagram illustrating a crystalline film separated from a substrate for growth and the state of crystal axes.
[FIG.6] A schematic diagram illustrating a step of attaching the crystalline film illustrated in FIG. 5 to a polishing board.
[FIG.7A, FIG.7B and FIG.7C] Schematic diagrams illustrating steps of polishing a conventional crystalline film.
[FIG.8] A schematic diagram illustrating the conventional crystalline film having both polished surfaces and the state of crystal axes.

### Reference Signs List

- 1: substrate for epitaxial growth
- 2: low-temperature buffer layer
- 3: crystalline film
- 4: reformed region pattern
- 5: pulsed laser
- 6: pitch

### Description of Embodiment

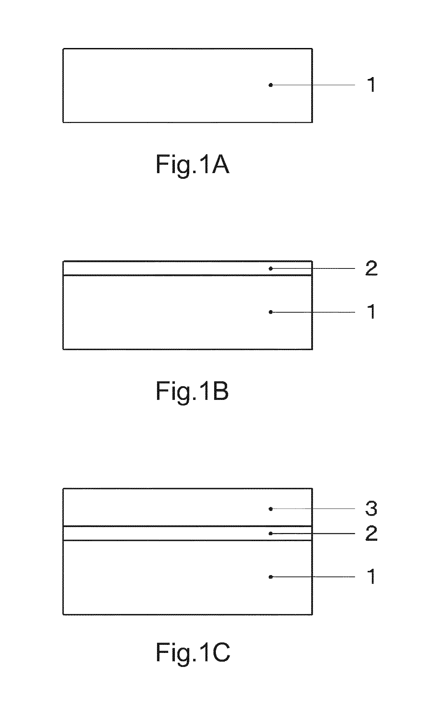

Hereinbelow, a crystalline film, a device, and manufacturing methods for the crystalline film and the device according to the present invention are described with reference to FIGS. 1 to 4. FIGS. 1 are schematic diagrams illustrating epitaxial growth steps for a crystalline film according to an embodiment of the present invention.

The crystalline film of the present invention has a feature that the crystalline film is formed on a substrate for epitaxial growth (hereinafter, referred to as a "substrate for growth") so as to have a thickness of 300 µm or more and 10 mm or less by epitaxial growth, is separated from the substrate for growth, and has a reformed region pattern formed in its internal portion.

On the surface of a crystal growth surface of a substrate for growth 1 illustrated in FIG. 1A, a low-temperature buffer layer 2 is epitaxially grown, as illustrated in FIG. 1B. In addition, as illustrated in FIG. 1C, a crystalline film 3 is formed by epitaxial growth. An example of the crystalline film 3 includes a film of a nitride semiconductor crystal, and a more specific example thereof includes a Group III nitride-based compound semiconductor represented by GaN.

With regard to a material for the substrate for growth 1, a single crystal of any one of sapphire (Al₂O₃), Si, GaAs, crystal, and Ga₂O₃ is preferable as a material capable of forming the nitride semiconductor film. Among them, when the crystalline film 3 is made of GaN, sapphire is most preferable because the lattice constant of sapphire is gradually changed and relaxed as the film thickness of GaN is increased.

The crystal growth surface of the substrate for growth 1 is subjected to polishing in advance before the crystalline film 3 is epitaxially grown, and the polishing may appropriately be performed so that the crystal growth surface becomes smooth to the extent that epitaxial growth is allowed. Regarding the extent that epitaxial growth is allowed, the crystal growth surface is preferably formed to have a surface roughness Ra of 0.1 nm or less.

Further, as the crystal growth surface of the substrate for growth 1 made of sapphire for forming the crystalline film 3, the C-plane is preferable. However, the crystal growth surface is not limited thereto, and the R-plane, the M-plane, and the A-plane other than the C-plane can also be used.

Further, thermal cleaning is performed on the substrate for growth 1 having the polished crystal growth surface, the low-temperature buffer layer 2 is epitaxially grown, and then the crystalline film 3 is epitaxially grown via the low-temperature buffer layer 2. As the epitaxial growth method for the crystalline film 3, the HVPE method is preferable. The reason for this is that the HVPE method is capable of film formation without performing complicated steps, thereby achieving a growth rate higher than that of the MOCVD method or MBE method to grow thick GaN when the crystalline film 3 is made of GaN, and is excellent in the reduction of defect density of GaN and mass productivity. Through the HVPE method, the free-standing crystalline film 3 having a thickness of 300 µm or more and 10 mm or less is grown and formed (see FIG. 1C).

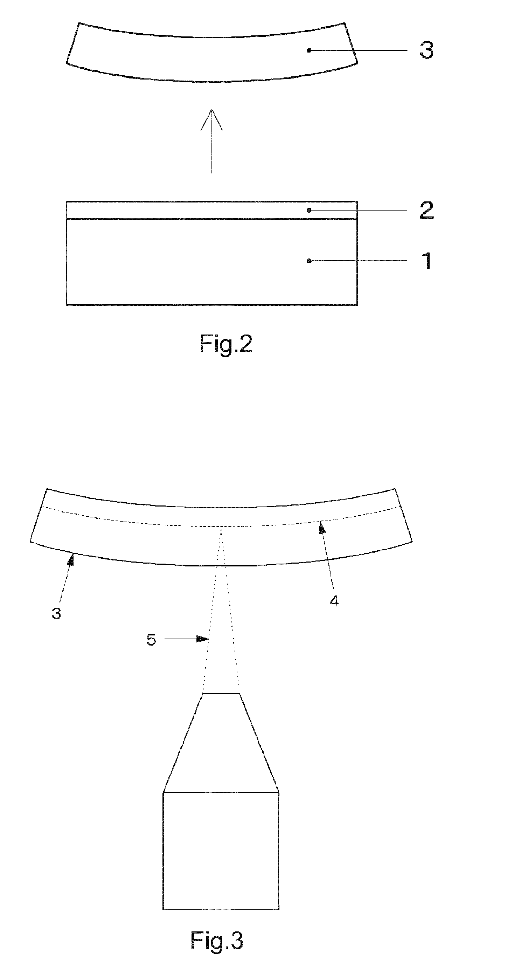

Next, as illustrated in FIG. 2, the crystalline film 3 is delaminated to be separated from the substrate for growth 1. Even when the crystalline film 3 could be grown and formed to such a thickness that the crystalline film 3 is capable of free-standing, in the process of separating and removing the crystalline film 3 from the substrate for growth 1, the internal strain resulting from differences in thermal expansion coefficient and lattice constant between the substrate for growth 1 and the crystalline film 3 made of the nitride semiconductor crystal is released. As a result, as illustrated in FIG. 2, warpage occurs in the crystalline film 3.

To cope with this, subsequently, the crystalline film 3 is placed on a sample stage, a pulsed laser 5 is concentrated onto the internal portion of the crystalline film 3 through a surface along the convex shape of the crystalline film 3, and the sample stage (not shown) is consecutively scanned at a high speed, as illustrated in FIG.3. Through this concentration and scanning step, a linear reformed region pattern 4 in which spot-like reformed regions are consecutively linked together is formed in the internal portion of the crystalline film 3. Note that, the incidence of the pulsed laser can also be performed through a surface along the concave shape opposite to the surface along the convex shape.

The method of forming the reformed region pattern 4 is not particularly limited, and the method involving irradiating the pulsed laser 5 is used in this embodiment. In this case, by multiphoton absorption of atoms present in a region irradiated with the pulsed laser, the region is locally heated and denaturalization such as a change in crystal structure or crystallinity from that in the surrounding region occurs. In this manner, the reformed region is formed.

When viewed locally, the spot-like reformed region is formed only in a portion where the pulsed laser is momentarily applied, and the size of the reformed region depends on the spot size, irradiation energy, and pulse width of the pulsed laser 5. In addition, the length of the linearly formed spot-like reformed region pattern 4 is determined depending on the pulse rate of the pulsed laser and the scanning speed of the sample stage.

As the wavelength of the pulsed laser 5, a wavelength in a transparent wavelength range that is longer than an absorption edge wavelength of the crystalline film 3 is suitable. The pulse width and the irradiation energy are appropriately selected depending on physical properties of the material of the crystalline film 3.

The irradiation of the laser may be performed under any irradiation condition as long as the reformed region can be formed. In general, the pulsed laser 5 can concentrate energy in a short time width, and hence the use of the pulsed laser 5 that intermittently emits laser light is preferable in that a high peak output can be obtained.

When the crystalline film 4 is made of GaN, the wavelength of the pulsed laser 5 is preferably 200 nm or more and 5,000 nm or less, the pulse width is a nanosecond to a femtosecond, preferably 10 ns to 19 ns or 200 fs to 800 fs, and the pulse rate is preferably 50 kHz to 500 kHz. The laser power is preferably 0.05 to 0.8 W, the irradiation energy is preferably 3 to 20 µJ, and the spot size of the laser is preferably 0.5 to 4 µm. The scanning speed of the sample stage is preferably 100 to 1,000 mm/s, in consideration of mass productivity.

In addition, as illustrated in FIGS. 4, by optimizing the pattern shape, a pitch 6 between individual lines, and the formation position of the reformed region pattern 4, it is possible to control the internal stress of the entire crystalline film 3, to thereby control the warpage shape and/or the warpage amount of the crystalline film 3 with high precision. Note that, the warpage amount as used in the present invention refers to a distance between the peripheral portion and the central portion of the crystalline film 3 in the thickness direction of the crystalline film 3.

As the pattern shape of the reformed region pattern 4, for example, as illustrated in FIGS. 4, it is possible to form the pattern shape having, as its planar shape in a planar direction of the crystalline film 3, a stripe shape (FIGS. 4A and 4B) in which a plurality of lines are formed to be perpendicular to or in parallel to an orientation flat plane of the crystalline film 3, and the pattern shape having a lattice shape (FIG. 4C) in which the plurality of lines are formed to be perpendicular to and in parallel to the orientation flat plane thereof. Besides those shapes, it is also possible to form the pattern shape having, as its planar shape, a shape in which a plurality of polygons are disposed (hexagons in the example of FIG. 4D), a concentric shape (FIG. 4E), a spiral shape, or a shape in which a plurality of circles or ellipses identical in shape and size are regularly disposed. Note that, the polygon described above includes shapes other than a quadrangle.

The pattern shape mainly influences the symmetry of the warpage shape of the crystalline film 3. Therefore, in order to evenly reduce the warpage amount or evenly eliminate the warpage amount in the plane of the crystalline film 3 subj ected to double-sided polishing after the formation of the reformed region pattern 4, the planar shape of the pattern shape is preferably the lattice shape, the shape in which polygons are disposed, the concentric shape, the spiral shape, the shape in which a plurality of circles or ellipses identical in size and shape are regularly disposed, or a shape that is substantially symmetric with respect to a straight line passing through the center point of the crystalline film 3 or with respect to the center point of the crystalline film 3. Conversely, when the planar shape is the stripe shape, it is also possible to unevenly reduce or eliminate the warpage amount of the crystalline film 3 subjected to double-sided polishing after the formation of the reformed region pattern 4. In addition, it is sufficient to perform pulsed laser scanning only in one of vertical and lateral directions so that the step of irradiating the pulsed laser 5 is further facilitated.

Further, the lattice shape is adopted as the planar shape of the reformed region pattern 4 provided in the crystalline film 3, and the reformed region pattern 4 having the lattice shape can be used as division lines of a device chip when a device is formed in the end. In this case, it is preferable to form the reformed region pattern 4 having the lattice shape at a position in a thickness direction that allows the reformed region pattern 4 having the lattice shape to remain in a portion left after the double-sided polishing of the crystalline film 3.

The pitch 6 between the individual lines in the pattern of any one of the stripe shape, the lattice shape, the shape in which a plurality of polygons are disposed, and the concentric shape mainly influences the change amount of the warpage amount of the crystalline film 3 after the formation of the reformed region pattern 4. As the pitch 6 is reduced, the change amount of the warpage amount is increased. On the other hand, as the pitch 6 is set to be narrower, the processing time is prolonged, and hence, in consideration of mass productivity, the pitch 6 is preferably in a range of 50 µm or more and 2,000 µm or less, and is further preferably in a range of 100 µm or more and 1,000 µm or less.

The formation position of the reformed region pattern 4 in the thickness direction of the crystalline film 3 mainly influences the change amount of the warpage amount of the crystalline film 3 after the formation of the reformed region pattern 4. As the formation position is closer to the surface, the change amount of the warpage amount is increased. When the relative position of the reformed region pattern 4 in the thickness direction of the crystalline film 3 is assumed to be 0% at one surface of the crystalline film 3 (the surface on the side with the concave warpage, the upper surface of FIG. 3) as the reference value and 100% at the other surface (the surface on the side with the convex warpage, the lower surface of FIG. 3), the reformed region pattern 4 is preferably formed at a position of 3% or more and 95% or less in the thickness direction of the crystalline film 3, and further preferably 3% or more and less than 50%. Through formation of the reformed region pattern 4 at the position in the thickness direction described above, it becomes possible to prevent the formation of the reformed region pattern 4 from affecting the surface of the crystalline film 3. Note that, a plurality of the reformed region patterns may also be formed at different positions in the thickness direction of the crystalline film 3.

Through formation of the reformed region pattern 4 at the above-mentioned formation position in the thickness direction, the warpage amount occurring in the crystalline film 3 is reduced or eliminated. In this case, it is basically desirable to render the crystalline film 3 as flat as possible by eliminating the warpage amount, but it is also sufficient to reduce the warpage amount with the orientation of the warpage maintained as it is.

When the reformed region pattern 4 is provided at a deviated position, irregularly disposed, or asymmetrically disposed in the thickness direction of the crystalline film 3, there is a fear that it becomes difficult to reduce or eliminate the warpage amount, or the shape of the crystalline film 3 is strained. In order to avert the above-mentioned problem, the reformed region pattern 4 is preferably provided so as to be in parallel to at least one of the surfaces of the crystalline film 3 in the thickness direction of the crystalline film 3.

Thus, according to the present invention, as described above, through formation of the reformed region pattern 4 in the internal portion of the crystalline film 3, it is possible to obtain the crystalline film 3 in which the warpage shape is controlled and the warpage amount is reduced or eliminated with high precision. With this, through flattening of the crystalline film 3, it becomes possible to facilitate the subsequent step, and reduce or eliminate variations in crystal axis angle inside the crystalline film 3 subjected to double-sided polishing after the formation of the reformed region pattern 4. In addition, through use of the pulsed laser 5, the degree of the reduction in warpage amount can be checked while the crystalline film 3 is irradiated with the pulsed laser 5, and hence it becomes possible to shorten the step of reducing or eliminating the warpage amount as compared with a conventional step.

Further, when the reformed region pattern 4 is formed at a position of at least 3% or more and less than 50% in the thickness direction of the crystalline film 3, it becomes possible to cause the reformed region pattern 4 to remain in the internal portion of the crystalline film 3 even when the both surfaces of the crystalline film 3 are subjected to the polishing in the subsequent step. Consequently, the recurrence of the warpage in the crystalline film 3 is prevented and the occurrence of or increase in variations in crystal axis angle can be prevented.

Further, even when a large-diameter substrate having a diameter of 50 mm or more and 300 mm or less is used as the substrate for growth 1 and a large-diameter crystalline film 3 having the same size is produced, variations in crystal axis angle are reduced or eliminated by reducing or eliminating the warpage amount in the crystalline film 3 subjected to double-sided polishing after the formation of the reformed region pattern 4, and hence in-plane unevenness can also be prevented.

Moreover, when a light emitting element (for example, an LED) device using, for example, a GaN-based compound semiconductor is manufactured by using the above-mentioned crystalline film 3, the crystalline film 3, an n-GaN-based layer, an In-GaN-based active layer, and a p-GaN-based layer are successively stacked and the surface is appropriately etched, and then an n-type electrode and a p-type electrode are formed on the surface. Thereafter, the film is cut into individual one-chip light emitting elements.

In addition to the above-mentioned light emitting element device, there can be considered various devices using nitride semiconductors such as a light emitting device to be used in a surface emitting laser or the like, a light receiving device to be used in an optical sensor or a solar cell, and a semiconductor device to be used in an electronic circuit or the like.

By performing various subsequent steps on the crystalline film 3 of this embodiment produced by the above-mentioned manufacturing method and the double-sided polishing, it is possible to produce various devices. In this case, in the subsequent step, by performing at least an element portion formation step of performing at least a patterning process on the crystalline film 3 to produce an element portion functioning as any one selected from the group consisting of a light emitting element, a photovoltaic element, and a semiconductor element, it is possible to manufacture a device including the element portion and a crystalline film having a size substantially corresponding to the element portion. In addition, in the production of the device, besides the element portion formation step, a polishing step, a line-for-division formation step, and a division step may be performed in the stated order as subsequent steps.

In this case, in a manufacturing method for a device using the crystalline film 3 of this embodiment, specifically, by successively performing at least steps described in the following (1) to (4), it is possible to produce the device including the element portion and the crystalline film having the size substantially corresponding to the element portion.
(1) An element portion formation step of patterning the crystalline film 3 of this embodiment to form individual element portions.
(2) A polishing step of polishing one surface of the crystalline film 3 with the element portions formed on the other surface such that the reformed region pattern 4 is not completely removed.
(3) A line-for-division formation step of applying a laser along a boundary line between the individual element portions from the side of the surface polished in the polishing step to form a line for division.
(4) A division step of applying an external force along the line for division formed in the line-for-division formation step to divide the crystalline film 3 with the element portions on a per element portion basis.

With the above-mentioned steps, it becomes possible to obtain various devices each having at least a part of the crystalline film 3 of the present invention, and hence it is possible to obtain any one of a light emitting device such as the LED or the like, an electronic device, and a light receiving element by using the crystalline film 3 in which variations in crystal axis angle are reduced or eliminated. It is possible to provide various devices in which quality and device properties are improved by using the crystalline film 3 in which variations in crystal axis angle are reduced or eliminated.

## Claims

1. A crystalline film, comprising a reformed region pattern formed in an internal portion of the crystalline film,
wherein the crystalline film has a thickness of 300 µm or more and 10 mm or less.

2. A crystalline film according to claim 1, wherein the reformed region pattern is formed by a pulsed laser.

3. A crystalline film according to claim 1 or 2, wherein, when a relative position of the reformed region pattern in a thickness direction of the crystalline film is assumed to be 0% at one surface of the crystalline film and 100% at another surface of the crystalline film, the reformed region pattern is provided in a range of 3% or more and 95% or less in the thickness direction of the crystalline film.

4. A crystalline film according to claim 3, wherein the reformed region pattern is provided in a range of 3% or more and less than 50% in the thickness direction of the crystalline film.

5. A crystalline film according to any one of claims 1 to 4, wherein the reformed region pattern is provided in parallel to the one surface of the crystalline film.

6. A crystalline film according to any one of claims 1 to 5, wherein the reformed region pattern has, in a planar direction of the crystalline film, any one of a stripe shape, a lattice shape, a shape in which a plurality of polygons are disposed, a shape in which a plurality of circles or ellipses identical in shape and size are regularly disposed, a concentric shape, a spiral shape, and a shape substantially symmetric with respect to a straight line passing through a center point of the crystalline film or with respect to the center point of the crystalline film.

7. A crystalline film according to any one of claims 1 to 5, wherein:
the reformed region pattern has, in a planar direction of the crystalline film, any one of a stripe shape, a lattice shape, a shape in which a plurality of polygons are disposed, and a concentric shape; and
the reformed region pattern has, in the planar direction of the crystalline film, a pitch between lines constituting the reformed region pattern, the pitch being in a range of 50 µm or more and 2,000 µm or less.

8. A crystalline film according to claim 7, wherein the pitch is in a range of 100 µm or more and 1,000 µm or less.

9. A crystalline film according to any one of claims 1 to 8, wherein the crystalline film has a diameter of 50 mm or more and 300 mm or less.

10. A crystalline film according to any one of claims 1 to 9, wherein the crystalline film is a nitride semiconductor crystal.

11. A device, comprising at least a part of the crystalline film according to any one of claims 1 to 10.

12. A manufacturing method for a crystalline film, comprising:
forming the crystalline film having a thickness of 300 µm or more and 10 mm or less on a surface of a single crystal substrate by epitaxial growth;
subsequently separating the crystalline film from the single crystal substrate; and
subsequently forming a reformed region pattern by, when a relative position of the reformed region pattern in a thickness direction of the crystalline film in which warpage has occurred after the separating from the single crystal substrate is assumed to be 0% at a surface of the crystalline film on a concavely warped side and 100% at a surface of the crystalline film on a convexly warped, concentrating a pulsed laser onto an internal portion of the crystalline film in a range of 3% or more and less than 50% in the thickness direction to scan the internal portion, and using multiphoton absorption by the pulsed laser.

13. A manufacturing method for a crystalline film according to claim 12, wherein the forming of the reformed region pattern comprises providing the reformed region pattern in parallel to one surface of the crystalline film.

14. A manufacturing method for a crystalline film according to claim 12 or 13, wherein the forming of the reformed region pattern comprises forming the reformed region pattern into, in a planar direction of the crystalline film, any one of a stripe shape, a lattice shape, a shape in which a plurality of polygons are disposed, a shape in which a plurality of circles or ellipses identical in shape and size are regularly disposed, a concentric shape, a spiral shape, and a shape substantially symmetric with respect to a straight line passing through a center point of the crystalline film or with respect to the center point of the crystalline film.

15. A manufacturing method for a crystalline film according to claim 12 or 13, wherein the forming of the reformed region pattern comprises :
forming the reformed region pattern into, in a planar direction of the crystalline film, any one of a stripe shape, a lattice shape, a shape in which a plurality of polygons are disposed, and a concentric shape; and
setting, in the planar direction of the crystalline film, a pitch between lines constituting the reformed region pattern to be in a range of 50 µm or more and 2,000 µm or less.

16. A manufacturing method for a crystalline film according to claim 15, wherein the setting of the pitch comprises setting the pitch to be in a range of 100 µm or more and 1,000 µm or less.

17. A manufacturing method for a crystalline film according to any one of claims 12 to 16, wherein the crystalline film has a diameter of 50 mm or more and 300 mm or less.

18. A manufacturing method for a crystalline film according to any one of claims 12 to 17, wherein the crystalline film is a nitride semiconductor crystal.

19. A manufacturing method for a device, comprising:
forming a crystalline film having a thickness of 300 µm or more and 10 mm or less on a surface of a single crystal substrate by epitaxial growth;
subsequently separating the crystalline film from the single crystal substrate;
subsequently forming a reformed region pattern by, when a relative position of the reformed region pattern in a thickness direction of the crystalline film in which warpage has occurred after the separating from the single crystal substrate is assumed to be 0% at a surface of the crystalline film on a concavely warped side and 100% at a surface of the crystalline film on a convexly warped, concentrating a pulsed laser onto an internal portion of the crystalline film in a range of 3% or more and less than 50% in the thickness direction to scan the internal portion, and using multiphoton absorption by the pulsed laser, thereby manufacturing the crystalline film;
then performing at least an element portion formation step of performing at least a patterning process on the crystalline film to produce an element portion functioning as an element selected from the group consisting of a light emitting element, a photovoltaic element, and a semiconductor element; and
manufacturing the device including the element portion and the crystalline film having a size substantially corresponding to the element portion.
